# EUROPEAN PATENT APPLICATION

(11) **EP 0 989 596 A1**
(43) Date of publication of application: **29.03.2000**
(21) Application number: 98924567.5
(22) Date of filing: 10.06.1998
(51) Int. Cl.: H01L 21/02, H01L 21/027, H01L 21/30, H01L 21/46, H01L 21/68, H01L 27/12

(54) **SUBSTRATE FOR DEVICE MANUFACTURING, PROCESS FOR MANUFACTURING THE SUBSTRATE, AND METHOD OF EXPOSURE USING THE SUBSTRATE**

(30) Priority: 12.06.1997 JP 15484497
(71) Applicant: Nikon Corporation, Tokyo 100-0005 (JP)
(72) Inventor: SHIRAISHI, Naomasa, Chiyoda-ku, Tokyo 100-0005 (JP)
(74) Representative: Wiebusch, Manfred
(86) International application number: JP9802566
(87) International publication number: WO9857361

(57) **Abstract**

A device producing substrate having a depression not passing through the substrate from the front to back formed on the surface of the substrate. The depression preferably has an area of an extent which can be used as a mark for prealignment. The depression preferably is formed at least at part of the outer periphery of the substrate. The depression means any sort of depression not passing through the substrate and is used in a sense including a notch, hollow, hole, etc. In the device producing substrate, it is possible to use a dark-field imaging type microscope with an oblique incidence illumination or a differential interference microscope with an oblique incidence illumination to easily detect the position of the depression and possible to perform pre-alignment based on the result of detection. Further, in this device producing substrate, the depression used for the pre-alignment is formed not to pass through the substrate from the front to back, so less stress concentration occurs compared with a conventional orientation flat or notch.

## Description

The present invention relates to a silicon wafer used for example when producing a semiconductor device or another device producing substrate, a method of production thereof, and a method of exposure for transferring a mask pattern using that substrate.

### BACKGROUND ART

When producing an LSI or other semiconductor device, it is usually necessary to form as much as several dozen layers of circuit patterns on a silicon wafer or other semiconductor substrate all accurately aligned with respect to each other. To performing this alignment with a high accuracy, an alignment mark (wafer mark) is formed together with the circuit pattern at each shot region on the surface of the semiconductor substrate. Further, when using a stepper or other exposure apparatus to transfer a mask pattern on the second or later layers of the semiconductor substrate, an alignment sensor provided at the exposure apparatus detects a predetermined alignment mark and aligns the mask pattern with the circuit pattern in the shot region on the wafer based on the result of the detection.

At the time of such high accuracy mark detection, however, it is necessary to get the alignment mark to be detected into the detectable region of the alignment sensor, so relatively low accuracy alignment detection is performed based on the circumferential shape of the wafer in a pre-alignment step in advance. To detect position using such a circumferential shape criteria, an orientation flat or notch or other removed portion has been provided at the outer periphery of a conventional semiconductor substrate to pass through the substrate from the front to back. The position of the removed portion provided at the outer periphery of the substrate in this way has been used as the criteria for the pre-alignment of the two-dimensional position and rotational angle of the substrate.

A conventional semiconductor substrate, in this way, is provided with a removed portion passing through the substrate for detection of position using the shape criteria. In a semiconductor substrate formed with such a removed portion, however, the stress and strain occurring in the substrate concentrate at the removed portion during the heat processes accompanying production of the device or during the formation of a film with a high tension. This causes a deterioration in the planarity around the removed portion and causes deformation in the in-plane direction and therefore has had the problem of causing a deterioration in the properties of the device formed near the removed portion.

Further, in a conventional exposure apparatus, pre-alignment has been performed assuming the existence of an orientation flat or notch or other removed portion passing through the substrate, so pre-alignment is liable to become difficult when eliminating such a removed portion from the semiconductor substrate.

### DISCLOSURE OF THE INVENTION

The present invention was made in consideration of this situation and has as its object the provision of a device producing substrate resistant to the occurrence of stress and strain due to stress concentration and enabling pre-alignment, a method of production of a device producing substrate, and a method of exposure enabling alignment using such a device producing substrate.

To achieve the above object, the device producing substrate according to the present invention is characterized by the formation of a depression not passing through the substrate from the front to back at the surface of the substrate. The depression preferably has an area of an extent able to be used as a mark for prealignment. The depression preferably is formed at least at part of the outer periphery of the substrate. Note that in the present invention, the "front" and the "back" of the substrate are relative concepts and are not definitively fixed. The surface of the substrate at the side where the depression of the present invention is formed is treated as the front, but the depression may also be formed at the back as well. Further, in the present invention, the "depression" means any sort of depression not passing through the substrate and is used in the sense including a notch, hollow, hole, etc.

In the device producing substrate according to the present invention, it is possible to easily detect the position of the depression by using a dark-field imaging type microscope with an oblique illumination or a differential interference microscope with an oblique illumination or the like and possible to perform prealignment based on the result of the detection. Further, in the device producing substrate according to the present invention, the depression used for the prealignment is formed so as not to pass through the substrate from the front to back, so stress concentration occurs less easily compared with the conventional orientation flat or notch. As a result, the planarity of the substrate is easily maintained and the properties of the semiconductor device built in the substrate are improved even during heat processes accompanying device production or during formation of films with strong tension. Further, since stress and strain do not easily occur near the depression. It is possible to form a semiconductor device etc. with a high accuracy even near the depression.

The substrate is not particularly limited. It may be a single layer substrate or a single layer substrate on the surface of which a single or multiple layers of thin films are stacked. Preferably, the substrate is comprised of a substrate body and a functional layer stacked on the surface of the substrate body and has the depression formed in the functional layer. Preferably, the substrate body is a silicon monocrystalline substrate. More preferably, the functional layer is comprised of an insulating layer stacked on the surface of the substrate body and a semiconductor layer stacked on the surface of the insulating layer. A substrate having such a functional layer is called a "silicon-on-insulator" (SOI) structure substrate. By providing a depression passing through only the semiconductor layer, it is possible to minimize the stress concentration due to the provision of the depression.

One or more depressions may be provided at the outer periphery of the substrate. When providing depressions at a plurality of locations at the outer periphery of the substrate, compatibility with substrate having the conventional plurality of notches is ensured.

The best mode of a device producing substrate according to the present invention is that of a device producing substrate covered on its surface with a thin film, characterized by the formation of an orientation flat or notch at part of the thin film. The device producing substrate is preferably an SOI wafer.

To achieve the above object, the method of producing a device producing substrate according to the present invention comprises a first step of forming a functional layer on the surface of a substrate body and a second step of forming a depression at part of the functional layer.

Preferably, the second step comprises a step of coating the surface of the functional layer with a photosensitive material to form a photosensitive layer, a step of exposing the surface of the photosensitive layer by a pattern corresponding to the depression, a step of developing the photosensitive layer which has been exposed, and a step of using the mask pattern of the developed photosensitive layer to etch at least part of the functional layer to form the depression.

Preferably, the functional layer comprises an insulating film stacked on the surface of the substrate body and a semiconductor layer stacked on the surface of the insulating layer and the semiconductor layer is etched to form the depression in the semiconductor layer using the insulating layer as an etching stopper layer to stop the etching at the surface of the insulating layer.

Preferably, the first step comprises a step of forming an insulating layer on the surface of a first monocrystalline substrate, a step of forming a planarization layer on the surface of the insulating layer, a step of bonding a second monocrystalline substrate to form the substrate body on the surface of the planarization layer, and a step of polishing the surface of the first monocrystalline substrate at the side opposite to the insulating layer to process the first monocrystalline substrate to a semiconductor layer of a predetermined thickness. By this method, it is possible to easily produce an SOI substrate having a monocrystalline thin film layer stacked on the surface of another monocrystalline substrate through an insulating layer. Preferably, the surface of the first monocrystalline substrate at the side opposite to the insulating layer is polished by chemical mechanical polishing.

Further, the first step may be comprised of a step of implanting oxygen ions so as to give a peak of the distribution of concentration of the impurity at a position of a predetermined depth from the surface of the monocrystalline substrate for forming the substrate body and a step of heat treating the substrate body after ion implantation to cause the oxygen ions implanted at a position of a predetermined depth from the surface of the substrate body to chemically bond with the elements of the monocrystal constituting the substrate body to form an insulating layer. It is possible to easily produce an SOI substrate having a monocrystalline thin film stacked on the surface of another monocrystalline substrate through an insulating layer by this method as well.

To achieve the above object, the method of exposure according to the present invention comprises a step of using a device producing substrate formed at the surface of the substrate with a depression not passing through the substrate from the front to back and detecting the position of the depression, a step of aligning the substrate based on the detected position of the depression, and a step of exposing the aligned substrate. The position of the depression on the substrate is preferably detected by the oblique incidence illumination system.

### BRIEF DESCRIPTION OF THE DRAWINGS

In the attached drawings,
- Fig. 1A: is a plan view of a wafer according to an embodiment of the present invention,
- Fig. 1B: is a front view of the wafer,
- Figs. 2A and 2B: are sectional views of key portions showing an example of the process of production of the wafer,
- Figs. 3A to 3E: are sectional views of key portions showing an example of the production of production of the wafer following Fig. 2B,
- Fig. 4: is a schematic view of the configuration of a projection exposure apparatus for projection exposure of the wafer shown in Fig. 1,
- Fig. 5: is an enlarged plan view of observation fields of wafer detection systems shown in Fig. 4,
- Figs. 6A to 6C: are schematic perspective views of the process of production of a wafer according to another embodiment of the present invention,
- Figs. 7A and 7B: are schematic perspective views of the process of production of a wafer according to still another embodiment of the present invention, and
- Figs. 8A to 8C: are schematic perspective views of the process of production of a wafer according to still another embodiment of the present invention.

### BEST MODE FOR CARRYING OUT THE INVENTION

Below, the present invention will be explained in detail based on embodiments shown in the drawings.

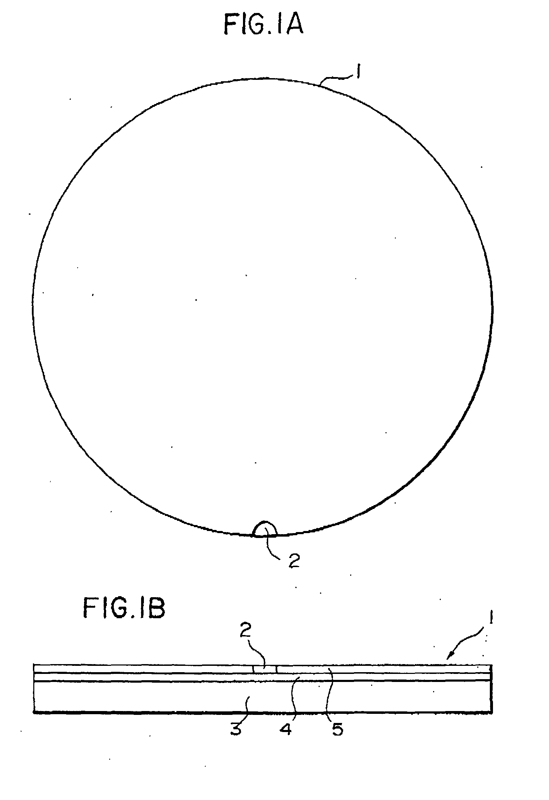

A wafer 1 shown in Figs. 1A and 1B and serving as the device producing substrate according to the present invention is a so-called silicon-on-insulator (SOI) structure silicon wafer. As shown in Fig. 1B, the wafer 1 of the present embodiment is provided with a substrate body 3 comprised of a monocrystalline silicon substrate having a thickness of 0.6 to 1 mm or so. On the surface of the substrate body 3 is stacked an insulating layer 4 comprised of silicon dioxide (SiO₂) having a thickness of 0.1 to 100 m or so and for example a semiconductor layer 5 comprised of a monocrystalline silicon layer having a thickness of 0.1 m or so.

As shown in Figs. 1A and 1B, the outer periphery of the wafer 1 of the present embodiment is formed with a substantially inverted V-shaped notch 2 (corresponding to the depression in the present invention) so as to pass through only the semiconductor layer 5 arranged at the topmost layer of the wafer 1. This notch 2 has a cutaway area of the same extent as a notch or orientation flat formed in a conventional wafer. The conventional notch, however, is formed so as to pass through the wafer substrate over its total thickness, while the notch 2 of the present embodiment is formed in only the semiconductor layer 5 of the topmost layer having a thickness of about 0.01% of the total thickness of the wafer as a whole and therefore differs remarkably in that point.

Accordingly, the stress concentration due to the existence of the notch 2 is remarkably lower than that of a conventional wafer substrate and the mechanical strength of the wafer 1 near the notch 2 is almost the same as that of other regions. Therefore, the wafer 1 does not suffer from stress concentration or stress and strain near the notch 2 even after a heat treatment process etc. and it is possible to form a circuit pattern with a high accuracy even in the shot region near the notch 2 at the time of exposure by an exposure apparatus. Further, at the time of pre-alignment of the wafer 1, it is possible to detect the position of the relatively shallow notch 2 using for example dark-field imaging type microscope with an oblique incidence illumination or differential interference microscope with an oblique incidence illumination and the like for alignment based on the outer shape criteria of the wafer 1 by substantially the same method as in the past.

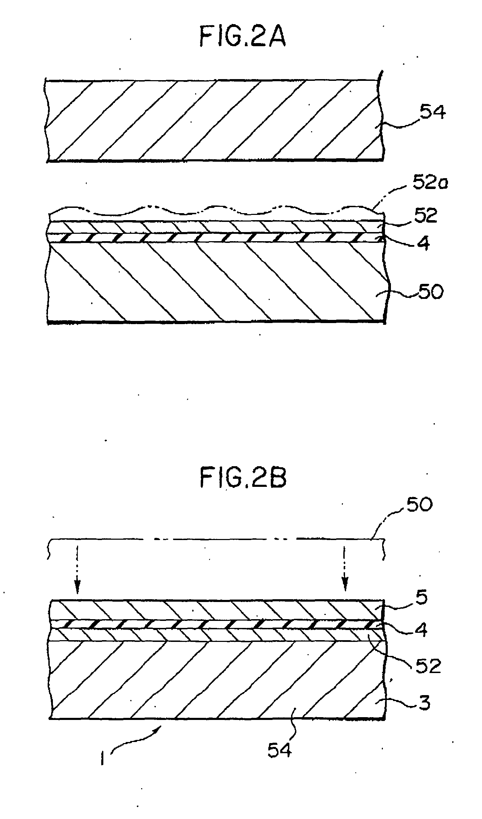

Next, an explanation will be made of an example of the method of production of the wafer 1 according to the present embodiment step by step with reference to Fig. 2.

In this embodiment, the case of producing the SOI structure wafer 1 by the bonding method will be explained.

### [First Step]

As shown in Fig. 2A, an insulating layer 4 comprised of silicon dioxide etc. is formed on the surface of a first monocrystalline substrate 50 comprised of a silicon monocrystalline wafer. The insulating layer 4 may be formed by thermal oxidation of the surface of the substrate 50. Further, it may be formed by depositing on the surface of the substrate 50 a thin film of silicon dioxide, silicon nitride, etc. by CVD. The thickness of the insulating layer 4 is not particularly limited, but is about 0.1 to 100 m in this embodiment.

It may also be considered to directly bond a second monocrystalline substrate 54 comprised of a silicon monocrystalline substrate etc. on the surface of the insulating layer 4, but in consideration of the ease of planarization and the ease of bonding, in the present embodiment, first a planarization layer 52 is formed on the surface of the insulating layer 4. The planarization layer 52 is formed for example by depositing a polycrystalline silicon or low melting point oxide film (for example, a BPSG film etc.) by CVD on the surface of the insulating layer 4. The surface 52a of the planarization layer 52 formed by CVD is a rough surface right after deposition. If left in that state, bonding of the second polycrystalline substrate 54 would be difficult. Therefore, in the present embodiment, the surface 52a of the planarization layer 52 is polished by chemical mechanical polishing (CMP). CMP is a technique which causes relative movement between a polishing pad and polishing object in the presence of a polishing agent to bring out the chemical function of the polishing agent and the mechanical function of the polishing pad and thereby enables good planarization of not only fine step differences, but even global step differences. The polishing agent is not particularly limited, but for example silicon dioxide (SiO₂) powder of a particle size of 8 to 50 nm dispersed in a solution of potassium hydroxide and adjusted in pH or alumina (Al2O3) powder dispersed in a solution of an oxidizing agent (for example, hydrogen peroxide solution) and adjusted in pH may be used. Note that the polishing pad is not particularly limited, but a porous polyurethane foam etc. may be used.

As a result of the polishing by CMP, the surface of the planarization layer 52 becomes flat. Next, that surface and the surface of the second monocrystalline substrate 54 are bonded together. The method of bonding includes a method using an adhesive and a method not using it. In the method using an adhesive, good bonding is possible between the surface of the substrate 54 and the surface of the planarization layer 52 to be bonded even if there is some roughness, but to improve the properties of the device built into the SOI substrate etc., it is preferable not to use an adhesive. As methods not using an adhesive, the heat bonding method, electrostatic bonding method, the anodic bonding method, etc. are known. To bond substrates without using an adhesive, the planarity of the bonded surfaces is important. At the time of bonding, heat treatment is performed for example at 1000 to 1100 C for 2 to 3 hours or so. The connection between the substrates is secured by the bonds of the silanol groups. In high temperature heat treatment, the connection between the substrates becomes strong because of siloxane bonds caused by dehydrogenation of the silanol groups. Note that when the planarization layer 52 is comprised of a BPSG layer, the temperature for connection of the substrates can be made lower. After bonding the substrate 50 and the substrate 54 in this way, as shown in Fig. 2B, the surface of the first monocrystalline substrate 50 at the side opposite to the insulating layer is polished to obtain an SOI structure wafer 1 having a semiconductor layer 5 comprised of relatively thin monocrystalline silicon on an insulating layer 4. The polishing at this time as well may be performed by the above CMP.

Note that the method for obtaining the SOI structure wafer 1 is not limited to the above embodiment. It is also possible to obtain this by the SIMOX (separation by implanted oxygen) method of implanting oxygen ions to give a peak of the distribution of concentration of the impurity at a position of a predetermined depth from the surface of the monocrystalline substrate to be the substrate body 3. By heat treating the substrate body 3 after ion implantation, it is possible to make the oxygen ions implanted at a position of a predetermined depth from the surface of the substrate body 3 chemically bond with the elements of the monocrystalline silicon constituting the substrate body 3 to form the insulating layer 4 comprised of silicon dioxide etc.

Further, when comprising the semiconductor layer 5 shown in Fig. 1B by a polycrystalline silicon etc., the entire surface of the substrate body 3 comprised of the silicon monocrystal etc. may be formed successively with an insulating layer 4 comprised of silicon dioxide and a semiconductor layer 5 by evaporation, sputtering, CVD, etc. In terms of the properties of the device built into the surface of the SOI structure wafer 1, however, the semiconductor layer 5 stacked on the insulating layer 4 is preferably a semiconductor layer 5 comprised of monocrystalline silicon rather than polycrystalline silicon.

### [Second step]

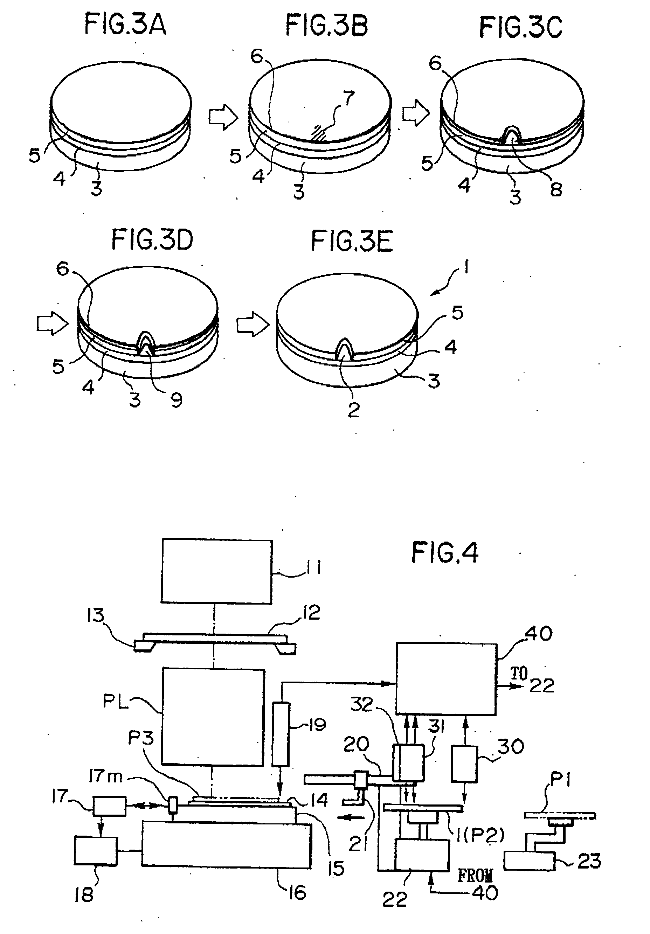

Using the SOI structure wafer 1 obtained in the first step, next, as shown in Fig. 3B, the surface of the topmost semiconductor layer 5 is coated with a resist 6 serving as a photosensitive material for forming a photosensitive layer. Note that the resist 6 may also be coated only partially at a small region on the surface of the semiconductor layer 5 including the region in which the notch is to be formed. Here, the resist 6 is assumed to be a positive type. A not shown exposure apparatus is used to expose the region 7 on the resist 6 where the notch is desired to be provided through a corresponding mask pattern.

Next, the resist 6 is developed to remove the portion 8 corresponding to the region 7 in the resist 6 as shown in Fig. 3C.

Next, as shown in Fig. 3D, the partially removed resist 6 is used as a mask for etching the semiconductor layer 5. At the time of the etching, an etchant suitable for etching the silicon constituting the semiconductor layer is used. Therefore, the insulating layer comprised of the silicon dioxide etc. present under the semiconductor layer 5 becomes the etching stopper layer and the control of the etching in the depth direction is permitted to be extremely rough. Further, the side etching characteristic in the in-plane direction need only be an accuracy of an extent required in the pre-alignment by the outer shape criteria (about 10 m), so an extremely inexpensive wet etching technique may be used. Due to this, as shown in Fig. 3D, a removed portion 9 is formed in the silicon layer 5.

Next, as shown in Fig. 3E, the remaining resist 6 is peeled off, whereby the removed portion 9 becomes a shallow notch (depression of the present invention) 2 and the wafer 1 shown in Figs. 1A and 1B is formed.

Note that in the above embodiment, the bonding technique shown in Figs. 2A and 2B is used to produce an SOI structure wafer 1, then a shallow notch 2 is formed. In the present invention, however, it is also possible to form a notch or orientation flat the same as in the past by a conventional known method at the outer periphery of the first monocrystalline substrate 50 to be bonded, then use the above-mentioned bonding technology to obtain an SOI structure wafer so as to form the notch 2 shown in Figs. 1A and 1B.

### [Method of Exposure]

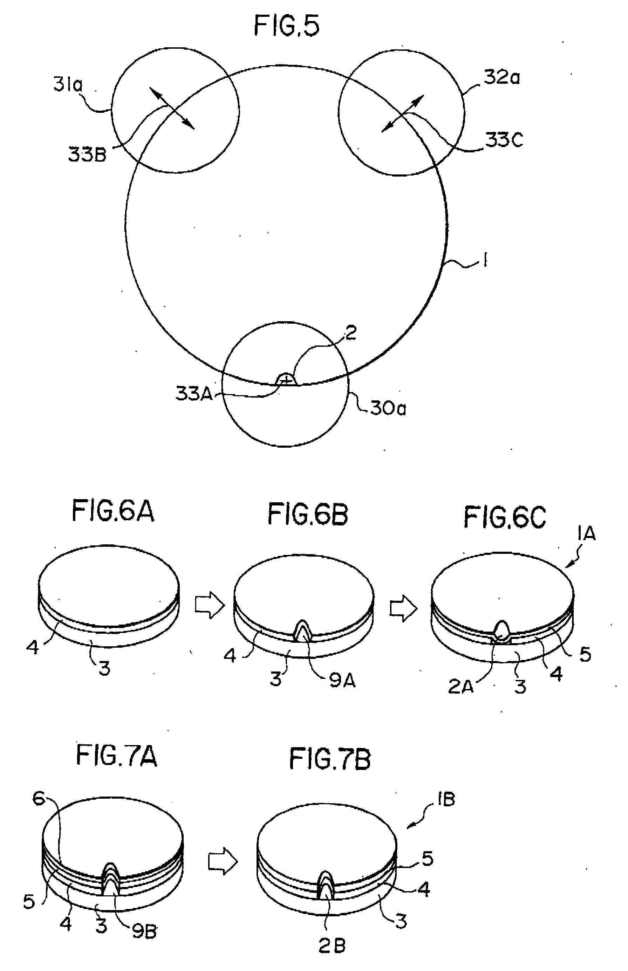

Next, an explanation will be given of an example of exposure of the mask pattern on the wafer 1 of the present embodiment shown in Fig. 1 with reference to Fig. 4 and Fig. 5. As the exposure apparatus for the wafer 1, any of an optical exposure apparatus using ultraviolet light etc. as the exposure energy beam or a charged particle beam exposure apparatus performing exposure using an electron beam etc. may be used, but here the explanation will be made of an example of use of an optical projection exposure apparatus.

Figure 4 shows the overall schematic configuration of a projection optical system used for exposure. As shown in Fig. 4, the exposure apparatus of the present embodiment is provided with an illumination optical system 11 containing an exposure light source, a fly's eye lens, and condenser lens. The reticle 12 serving as the mask is illuminated by the exposure light from the optical system 11 (excimer laser beam, mercury lamp i-rays and g-rays, etc.). The reticle 12 is held on a reticle stage 13 for positioning the reticle. The image of the pattern of the reticle 12 is transferred to the shot region of the wafer (not shown) through the projection optical system PL under this exposure light.

The wafer to be exposed is held on the wafer holder 14 by vacuum or by electrostatic force. The wafer holder 14 is secured on a sample table 15. The sample table 15 is positioned three-dimensionally by the wafer stage 16. The position of the sample table 15 (wafer) is detected by a moving mirror 17m on the sample table 15 and an outer laser interferometer 17. The detection signal is input to the main control system 40 for overall control of the operation of the apparatus as a whole. Based on the control signal of the main control system 40, the stage drive system 18 controls the operation of the wafer stage 16. Further, as one example, an off axis type image processing system alignment sensor 19 is arranged at the side part of the projection optical system PL. The alignment sensor 19 detects the position of the wafer mark (alignment mark) on the wafer to be exposed and supplies the result of the detection to the main control system 40. The main control system 40 aligns the wafer to be exposed based on the result of detection.

To detect the position of a wafer mark on a wafer through the alignment sensor 19 in this way, it is necessary to prealign the wafer by the outer shape criteria so that the wafer mark falls within the observation field of the alignment sensor 19. Therefore, a wafer loader system provided with a pre-alignment mechanism 22 is arranged in the side direction of the wafer stage 16.

The pre-alignment mechanism 22 is comprised of a stage able to be moved finely two-dimensionally in the translational direction and a turntable. Above the mechanism 22 are provided with three wafer detection systems 30 to 32 of oblique incidence illumination system imaging type. The imaging signals of the wafer detection systems 30 to 32 are supplied to an image processor in the main control system 40. Further, the wafer detection system 30 has a dark-field imaging type microscope so as to be able to detect the position of a low step difference mark etc., while the other wafer detection systems 31 and 32 are ordinary bright field imaging type microscopes. Further, in the state with the wafer 1 shown in Fig. 1 placed on the pre-alignment mechanism 22, the observation fields 30a to 32a of the wafer detection systems 30 to 32 are positioned at the peripheral edges of the wafer 1.

Figure 5 shows the relationship between the observation fields 30a to 32a on the pre-alignment mechanism 22 and the wafer 1. The notch 2 of the wafer 1 falls within the observation field 30a, while the edge portions of the wafer 1 fall within the other observation fields 31a and 32a. Further, the main control system 40 processes the imaging signal corresponding to the image in the observation field 30a to detect the two-dimensional position of the center 33A of the notch 2 and processes the imaging signals corresponding to the images in the other observation fields 31a and 32a to detect the positions 33B and 33C in the radial direction of the edges of the wafer 1. Based on these results of detection, the main control system 40 controls the alignment operation of the pre-alignment mechanism 22.

As shown in Fig. 4, a wafer handler 23 and a load slider 20 provided with a load arm 21 are provided at the right side and left side of the illustrated prealignment mechanism 22.

Next, an explanation will be made of the operation until the wafer 1 of the present embodiment is fed from the outside of the exposure apparatus and exposed by the exposure apparatus. First, a wafer 1 transported from for example a resist coater or other apparatus is temporarily held at the position P1 on the handler 23. Next, the wafer 1 is transported from the handler 23 to a position P2 on the pre-alignment mechanism 22. The image information (imaging signal) of the outer shape and notch 2 of the wafer 1 is supplied through the wafer detection systems 30 to 32 to the main control system 40. The main control system 40 finds from this image information the two-dimensional coordinates (WX, WY) of the center of the wafer 1 and the rotational angle W and finds the error of these values from the target values at the time of pre-alignment. Further, the main control system 40 corrects the position of the wafer 1 in the translational direction and the rotational angle through the pre-alignment mechanism 22 so that the error falls within a permissible range to complete the alignment.

The wafer 1 aligned by the pine-alignment mechanism 22 is transported by a load arm 21 movable along a load slider 20 and placed at a position P3 on the wafer holder 14. After the wafer 1 is picked up and held on the wafer holder 14, the position of a predetermined wafer mark formed together with a shot region on the wafer is detected by the alignment sensor 19. Based on the result of detection, the accurate position of the shot region on the wafer 1 is calculated. Next, while aligning the wafer 1, the pattern image of the reticle 12 is overlaid on the shot region of the wafer 1 through a projection optical system PL for exposure.

At this time, in the present embodiment, to detect the notch 2 of the topmost layer of the wafer 1 shown in Figs. 1A and 1B, a wafer detection system 30 having a dark-field imaging type microscope with an oblique incidence illumination is used. The notch 2 is deemed to be a step difference mark with a substantially uniform reflectivity, so the position of the notch 2 can be detected at a high accuracy by the wafer detection system 3. As opposed to this, since the conventional alignment mechanism is provided with a transmission illumination type microscope as a wafer detection system, such a step difference mark could not be detected. Note that in the observed fields 31a and 32a of Fig. 5, the edge of the wafer 1 is detected, so the corresponding wafer detection systems 31 and 32 may also be transmission illumination types.

The present invention is not limited to the above embodiment and can be modified in various ways within the scope of the invention.

For example, in the wafer 1 according to the embodiment shown in Figs. 1A and 1B, a notch 2 is formed at only part of the topmost silicon layer 5, but as shown in Figs. 6A to 6C, it is also possible to provide a notch 9A at just the insulating layer 4 comprised of silicon dioxide etc. and form the semiconductor layer 5 over it. In this case, as shown in Fig. 6C, a wafer 1A formed with a hollow 2A as a depression in the surface of the semiconductor layer 5 at the portion corresponding to the notch 9A of the insulating layer 4 is obtained. The hollow 2A of the wafer 1A also has a similar action as the notch 2 of the wafer 1 according to that embodiment.

Further, as shown in Figs. 7A and 7B, by using the resist 6 to successively etch the semiconductor layer 5 and insulating layer 4 to form the removed portion 9B and then removing the resist, it is possible to produce a wafer 1B formed with a notch 2B passing through only the semiconductor layer 5 and the insulating layer 4. This notch 2B of the wafer 1B also has a similar action as the notch 2 of the wafer 1 according to the above embodiment. The notch 2 formed at the wafer 1 shown in Figs. 1A and 1B, however, is shallower than the notch 2B formed in the wafer 1B shown In Fig. 7B, so the effect of easing the stress concentration is greater.

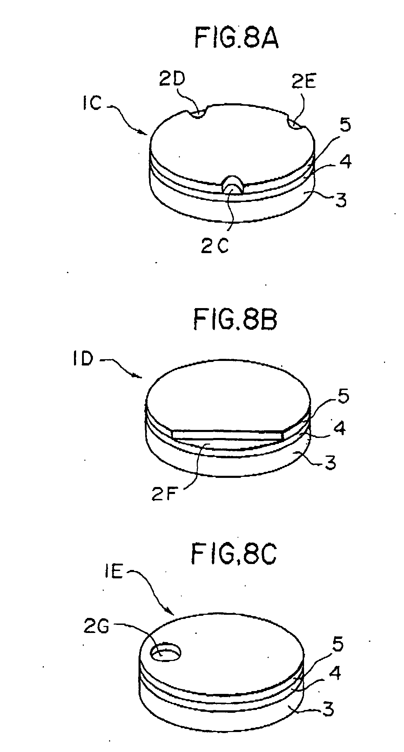

Further, in the present invention, as shown in Fig. 8A, notches 2C, 2D, and 2E may be provided at the topmost semiconductor layer 5 at a plurality of locations (three in Fig. 8A) contiguous with the outer peripheral edge of the wafer 1C. Of course, however, notches penetrating through not only the semiconductor layer 5, but even the insulating layer 4 may be provided and notches may be provided in only the insulating layer 4 (same below). In this case, by providing the notches 2C to 2E so as to be asymmetrical, that is, so as not to be at equiangular intervals about the center of the wafer 1C, it is possible to prevent erroneous recognition of the direction of orientation of the wafer 1C.

Further, as shown in Fig. 8B, a notch 2F similar to an orientation flat may be provided at the semiconductor layer 5. Due to this, the wafer 1D of the present embodiment retains compatibility to a certain extent with a conventional wafer provided with an orientation flat.

Further, as shown in Fig. 8C, a small hole 2G passing through only the semiconductor layer 5 may be provided at a region not contiguous with the outer peripheral edge of the wafer 1E. The area of the hole 2G is approximately the same extent as the area of the notch 2.

Further, while not shown, the substrate according to the present invention is not limited to an SOI structure wafer and for example may be a substrate having a notch at part of at least one layer of a substrate comprised of a silicon or gallium arsenic (GaAs) or other semiconductor substrate body on which is formed one or more thin films.

Further, even in an ordinary semiconductor substrate comprised of a silicon monocrystalline substrate, it is possible to produce a substrate having a shallow notch or other depression according to the present invention by thinly shaving the area near the surface.

Further, in the above embodiments, a shallow depression was provided over a small area at part of the wafer and that depression used for the pre-alignment, but it is also possible to make the majority of the surface of the wafer a depression, leave a thin projection at the portion contiguous with the peripheral edge of the wafer, and use that projection for pre-alignment. So long as the projection is thin, stress concentration will not be invited and further pre-alignment will be easy.

Further, in the above embodiments, the notch was provided at the wafer in the lithography step, but a shallow notch may also be formed by emitting a laser beam at part of the wafer using a repair use YAG laser or other laser processing apparatus.

## Claims

1. A device producing substrate wherein a depression not passing through the substrate from the front to back is formed at the surface of the substrate.

2. The device producing substrate as set forth in claim 1, wherein the substrate is comprised of a substrate body and a functional layer stacked on the surface of the substrate body and has the depression formed in the functional layer.

3. The device producing substrate as set forth in claim 2, wherein the functional layer is comprised of an insulating layer stacked on the surface of the substrate body and a semiconductor layer stacked on the surface of the insulating layer.

4. The A device producing substrate as set forth in any one of claims 1 to 3, wherein the depression has an area of an extent which can be used as a mark for pre-alignment.

5. The device producing substrate as set forth in any one of claims 2 to 4. wherein the substrate body is a silicon monocrystalline substrate.

6. The device producing substrate as set forth in any one of claims 1 to 5, wherein the depression is formed at least at part of the outer periphery of the substrate.

7. A method of production of a device producing substrate comprising:
a first step of forming a functional layer on the surface of a substrate body and
a second step of forming a depression at part of the functional layer.

8. The method of production of a device producing substrate as set forth in claim 7, wherein the second step comprises:
a step of coating the surface of the functional layer with a photosensitive material to form a photosensitive layer,
a step of exposing the surface of the photosensitive layer by a pattern corresponding to the depression,
a step of developing the photosensitive layer which has been exposed, and
a step of using a mask pattern of the developed photosensitive layer to etch at least part of the functional layer to form the depression.

9. The method of production of a device producing substrate as set forth in claim 8, wherein
the functional layer comprises an insulating film stacked on the surface of the substrate body and a semiconductor layer stacked on the surface of the insulating layer and
the semiconductor layer is etched to form the depression in the semiconductor layer using the insulating layer as an etching stopper layer to stop the etching at the surface of the insulating layer.

10. The A method of production of a device producing substrate as set forth in any one of claims 7 to 9, wherein the first step comprises:
a step of forming an insulating layer on the surface of a first monocrystalline substrate,
a step of forming a planarization layer on the surface of the insulating layer,
a step of bonding a second monocrystalline substrate to form the substrate body on the surface of the planarization layer, and
a step of polishing the surface of the first monocrystalline substrate at the side opposite to the insulating layer to process the first monocrystalline substrate to a semiconductor layer of a predetermined thickness.

11. The method of production of a device producing substrate as set forth in claim 10, wherein the surface of the first monocrystalline substrate at the side opposite to the insulating layer is polished by chemical mechanical polishing.

12. The method of production of a device producing substrate as set forth in any one of claims 7 to 9, wherein the first step comprises:
a step of implanting oxygen ions so as to give a peak of the distribution of concentration of an impurity at a position of a predetermined depth from the surface of the monocrystalline substrate for forming the substrate body and
a step of heat treating the substrate body after ion implantation to cause the oxygen ions implanted at the position of the predetermined depth from the surface of the substrate body to chemically bond with elements of monocrystal constituting the substrate body to form an insulating layer.

13. A method of exposure comprising:
a step of using a device producing substrate formed at the surface of the substrate with a depression not passing through the substrate from the front to back and detecting the position of the depression,
a step of aligning the substrate based on the detected position of the depression, and
a step of exposing the aligned substrate.

14. The method of exposure as set forth in claim 13, wherein the position of the depression on the substrate is detected by the oblique incidence illumination method.

15. A device producing substrate having a thin film formed on its surface, wherein an orientation flat or notch is formed at part of the thin film.

16. The device producing substrate as set forth in claim 15, wherein the device producing substrate is an SOI wafer.
